# DEMANDE DE BREVET EUROPEEN

(11) **EP 4 589 642 A1**
(43) Date de publication de la demande: **23.07.2025**
(21) Numéro de dépôt: 25152198.5
(22) Date de dépôt: 16.01.2025
(51) Int. Cl.: H01L 21/56, H01L 21/683, H01L 23/29, H01L 23/31

(54) **PROCÉDÉ DE FABRICATION DE PUCES ÉLECTRONIQUES À FLANCS PASSIVÉS**

(30) Priorité: 19.01.2024 FR 2400541
(71) Demandeur: STMicroelectronics International N.V., 1228 Plan-les-Ouates, Geneva (CH)
(72) Inventeur: DELACOURT, Gregoire, 37000 Tours (FR); FALLOURD, Ludovic, 37320 Louans (FR)
(74) Mandataire: Cabinet Beaumont

(57) **Abrégé**

La présente description concerne un procédé de fabrication d'une puce électronique (100) à flancs passivés à partir d'un substrat (110) semiconducteur dont une première face est recouverte par des plages de connexion (107) et dans lequel sont formées des puces, le procédé comprenant les étapes suivantes :
- déposer une couche de protection sur la première face du substrat (110),
- former des tranchées ou des cavités entre les puces,
- déposer une couche isolante (121) dans les tranchées ou dans les cavités par dépôt de couches atomiques,
- retirer la couche de protection (130).

## Description

### Domaine technique

La présente description concerne le domaine des puces de type CSP (`Chip-Scale Package'). Elle concerne plus particulièrement un procédé de fabrication de puces nues (« bare dice » ou « bare chip »).

### Technique antérieure

Les puces nues comprennent un substrat, en matériau semiconducteur-conducteur, dans lequel des circuits électroniques ont été fabriqués. Le substrat est recouvert par des plages de connexion afin de permettre un assemblage de la puce, par exemple, avec une carte de circuit imprimé. Lors de l'assemblage de la puce, les plages de connexion sont soudées ou brasées à des pistes ou éléments métalliques du circuit imprimé. Cependant, lors de l'assemblage, il arrive que la brasure remonte le long des flancs de la puce. Or, comme les flancs de la puce sont en matériau semiconducteur, cela peut entraîner une perte des performances électriques (court-circuit, courant de fuite...). Il existe donc un besoin d'éviter de tels phénomènes.

De telles puces sont intéressantes dans de nombreux domaines.

### Résumé de l'invention

Il existe un besoin d'améliorer au moins en partie certains aspects des procédés connus de fabrication des puces électroniques.

Ce but est atteint par un procédé de fabrication d'une puce électronique à flancs passivés à partir d'un substrat semiconducteur dont une première face est recouverte par des plages de connexion et dans lequel sont formées des puces, le procédé comprenant les étapes suivantes :
- déposer une couche de protection sur la première face du substrat,
- former des tranchées ou cavités entre les puces,
- déposer une couche isolante en céramique dans les tranchées ou dans les cavités par dépôt de couches atomiques,
- retirer la couche de protection.

Selon un mode de réalisation, des tranchées sont formées, les tranchées allant de la première face du substrat à une deuxième face du substrat.

Selon un mode de réalisation, des cavités sont formées en découpant partiellement le substrat depuis la première face.

Selon un mode de réalisation, le procédé comprend une étape au cours de laquelle le substrat est aminci à partir d'une deuxième face du substrat jusqu'à atteindre les cavités.

Selon un mode de réalisation, la couche isolante est en alumine.

Selon un mode de réalisation, la couche de protection est une couche soluble dans l'eau.

Selon un mode de réalisation, la couche de protection est une couche adhésive sensible au rayonnement ultra-violet.

Selon un mode de réalisation, avant ou après le dépôt de la couche isolante, le procédé comprend une étape au cours de laquelle la couche de protection est soumise à un rayonnement ultra-violet pour diminuer ses propriétés d'adhésion.

Selon un mode de réalisation, l'étape de retrait de la couche de protection est réalisée en collant une couche adhésive additionnelle et en retirant simultanément la couche adhésive additionnelle et la couche de protection.

Ce but est atteint par une puce électronique à flancs passivés comprenant un substrat semiconducteur, ayant une première face recouverte par des plages de connexion, une deuxième face et des flancs, au moins une partie des flancs étant formée d'une couche isolante en céramique s'étendant depuis la première face du substrat.

Selon un mode de réalisation, la couche isolante recouvre une partie de la première face.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1A, la figure 1B, la figure 1C, la figure 1D, la figure 1E et la figure 1F représentent des vues en coupe illustrant des étapes d'un procédé de fabrication de puces électroniques à flancs passivés selon un mode de réalisation particulier;

la figure 2A, la figure 2B, la figure 2C, la figure 2D, la figure 2E, la figure 2F et la figure 2G représentent des vues en coupe illustrant des étapes d'un procédé de fabrication de puces électroniques à flancs passivés selon un autre mode de réalisation particulier ;

la figure 3A, la figure 3B, la figure 3C, la figure 3D, la figure 3E et la figure 3F représentent des vues en coupe illustrant des étapes d'un procédé de fabrication de puces électroniques à flancs passivés selon un autre mode de réalisation particulier.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Le procédé de fabrication d'une puce (« bare dice » ou « bare chip ») à flancs passivés comprend au moins les étapes suivantes :
a) fournir un substrat 110 semiconducteur dont une première face 111 est recouverte par des plages de connexion 107 et dans lequel sont formées des puces,
b) déposer une couche de protection 130 sur la première face 111 du substrat 110, de manière à couvrir les plages de connexion 107,
c) former des tranchées ou des cavités 120 entre les puces 100,
d) déposer une couche isolante 121 en céramique dans les tranchées ou dans les cavités 120 par dépôt de couches atomiques,
e) retirer la couche de protection 130.

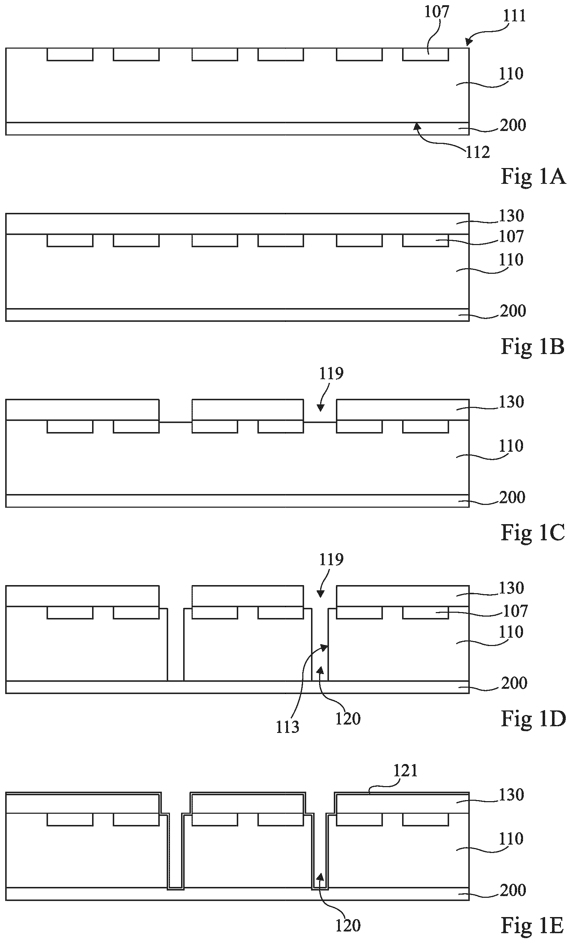

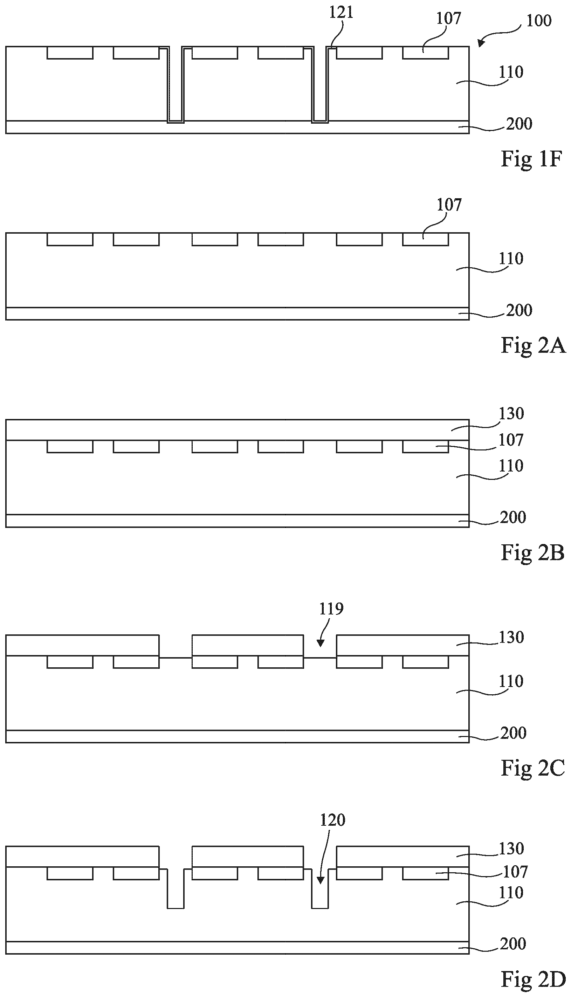

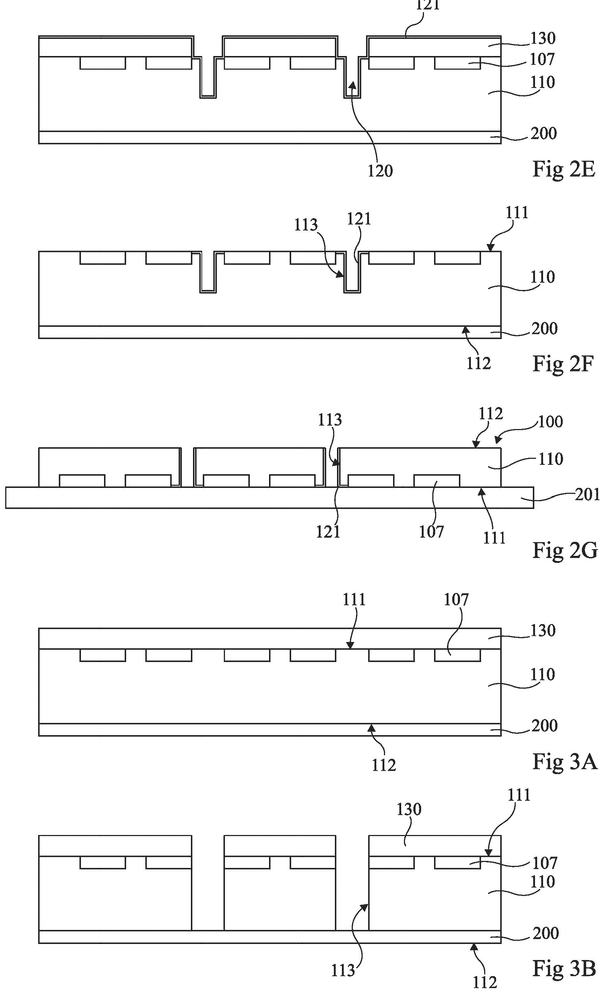

Selon une première variante de réalisation, en faisant référence aux figures 1A à 1F et 2A à 2G, le procédé de fabrication d'une puce électronique à flancs passivés comprend les étapes suivantes :
a) fournir un substrat 110 semiconducteur dont une première face 111 est recouverte par des plages de connexion 107 et dans lequel sont formées des puces 100 (figures 1A, 2A),
b) déposer une couche de protection 130 sur la première face 111 du substrat 110 (figures 1B, 2B), la couche de protection 130 étant soluble dans un solvant aqueux ou organique, de préférence, dans de l'eau,
   - de préférence, former des ouvertures 119 dans la couche de protection 130 (figures 1C, 2C),
c) former des tranchées ou des cavités 120 entre les puces 100, la largeur des tranchées 120 étant inférieure ou égale, de préférence inférieure, à la largeur des ouvertures 119 (figures 1D, 2D),
d) déposer une couche isolante 121 en céramique dans les tranchées ou dans les cavités 120 par dépôt de couches atomiques (figures 1E, 2E),
e) retirer la couche de protection 130 en la solubilisant dans le solvant aqueux ou organique (figures 1F, 2F),
   - éventuellement, amincir le substrat 110 en face arrière (figure 2G).

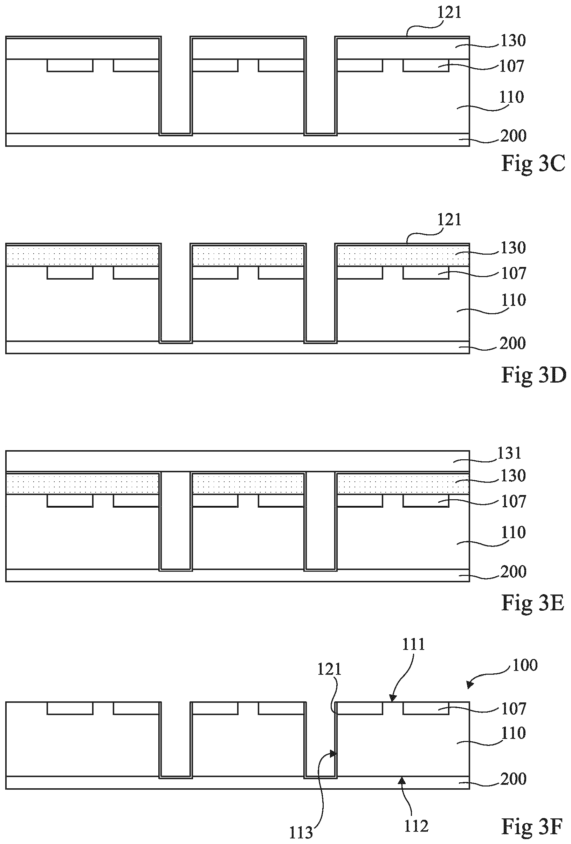

Selon une deuxième variante de réalisation, en faisant référence aux figures 3A à 3F, le procédé peut comprendre les étapes suivantes :
a) fournir un substrat 110 semiconducteur dont une première face 111 est recouverte par des plages de connexion 107 et dans lequel sont formées des puces 100,
b) déposer une couche de protection 130 sur la première face 111 du substrat 110 (figure 3A), par exemple une couche de protection sensible au rayonnement ultraviolet,
   - éventuellement, former des ouvertures 119 dans la couche de protection 130,
c) former des tranchées ou des cavités 120 entre les puces 100 (figure 3B),
d) déposer une couche isolante 121 en céramique dans les tranchées ou dans les cavités 120 par dépôt de couches atomiques (figure 3C),
   - réduire les propriétés adhésives de la couche de protection 130, par exemple en la soumettant à un rayonnement ultra-violet (figure 3D),
   - éventuellement, amincir le substrat 110 en face arrière,
e) retirer la couche de protection 130 (figures 3E et 3F), en collant une couche adhésive additionnelle 131, et en retirant simultanément la couche adhésive 130 et la couche adhésive additionnelle ('peeling').

Selon cette deuxième variante de réalisation, la couche de protection 130 a une adhésion à la fois suffisamment élevée pour adhérer lors de son dépôt et suffisamment faible, une fois ses propriétés adhésives réduites, afin de ne pas faire bouger les composants lors du retrait. Par exemple, la partie adhésive de la couche de protection est sensible au rayonnement ultra-violet.

Avec un tel procédé, les flancs 113 des puces 100 ainsi obtenues sont passivés au moyen d'une couche isolante 121. Une contamination potentielle (due à un assemblage déficient avec la carte) est ainsi évitée et il n'y a pas de dégradation des performances électriques.

A l'étape a), la fabrication du ou des composants discrets et/ou circuits intégrés est achevée. Les puces 100 sont formées dans un même substrat 110, et n'ont pas encore été individualisées.

Le substrat 110 comprend une première face 111 (face supérieure ou face avant) et une deuxième face 112 (face inférieure ou face arrière). Les deux faces 111 et 112 sont parallèles entre elles. Les faces 111 et 112 sont reliées entre elles par des parois latérales.

Le substrat 110 est, par exemple, un substrat semiconducteur, par exemple en silicium. Il peut également être en SiC.

Le substrat 110 a, par exemple, une épaisseur comprise entre 100 et 1200 µm, de préférence entre 300 et 900 µm, par exemple une épaisseur d'environ 725 µm.

Une ou plusieurs plages de connexion 107 (aussi appelés contacts électriques) sont formées sur la face supérieure 111 du substrat 110 la puce électronique 100 et permettent de la connecter à d'autres éléments (puces ou dispositifs électroniques). De préférence, au moins deux plages de connexion 107 sont formées sur la face supérieure 111 du substrat 110.

Les plages de connexion électrique 107 sont, par exemple, à une distance de 10 à 30 µm de la paroi latérale de la puce. Les plages de connexion électrique 107 peuvent être positionnées sur la face supérieure 111 de la puce 100 ou affleurer la face supérieure 111 (i.e. arriver au niveau de la face supérieure 111 de la puce 100).

Les plages de connexion électriques 107 sont aussi appelés « UBM » (pour l'expression anglo-saxonne « Under Bump Metallization »). Les plages de connexion électriques 107 sont en un matériau conducteur. Les plages de connexion électriques 107 comprennent, avantageusement, au moins un des éléments suivants : or, titane, nickel, cuivre ou tungstène. De préférence, elles comprennent de l'or.

La puce 100 peut comprendre un composant discret ou plusieurs composants discrets. Le ou les composants discrets sont, par exemple, choisis parmi les transistors, diodes, thyristors, triacs, filtres, etc. La puce 100 peut comprendre un ou plusieurs circuits électroniques. La puce 100 permet de mettre en oeuvre différentes fonctions électroniques.

Le substrat fourni à l'étape a) est positionné sur un support 200. Le support 200 est, généralement, de type adhésif.

Lors de l'étape b), une couche de protection est formée sur la première face 111 du substrat 110. La couche de protection recouvre les plages de connexion 107 et les protège lors du dépôt de la couche isolante 121.

Selon une première variante de réalisation avantageuse, la couche de protection 130 est une couche soluble dans un solvant. De préférence, elle est soluble dans l'eau. Par exemple, il s'agit d'un polymère comme la carboxyméthyl-cellulose. Il peut également s'agir d'un copolymère d'éthylène et d'acétate de Vinyle (VAE pour `Vinyl acetate - ethylene copolymer'), d'une émulsion d'éthylène et d'acétate de vinyl (EVA pour 'Ethylene vinyl acetate emulsions'), de l'alcool polyvinylique (PVOH pour `Polyvinyl alcohol'), d'une cellulose polyanionique (PAC pour `Polyanionic cellulose'). Les produits commercialisés sous la référence TOK TLDP-300 ou sous la référence DaeCoat peuvent également être choisis.

Selon une deuxième variante de réalisation avantageuse, la couche de protection 130 est une couche adhésive dont les propriétés adhésives peuvent être réduites lorsqu'elle est soumise à un facteur extérieur. Par exemple, elle peut avoir une sensibilité au rayonnement ultraviolet. Par sensibilité au rayonnement ultraviolet, on entend que, lorsque la couche est soumise à un rayonnement ultraviolet (typiquement entre 280 et 400 nm), ses propriétés d'adhésion diminuent fortement voire complètement. La couche 130 peut alors être facilement retirée en la tirant/arrachant ('peeling').

La couche de protection 130 peut être entièrement adhésive. Il s'agit, par exemple, d'une colle acrylique sur un film polymère pouvant être en polyéthylène (PE), Polyéthylène Téréphtalate (PET), en poly(chlorure de vinyle) (PVC) ou en polyoléfine (PO) et notamment en polyéthylène (PE) ou en polypropylène (PP).

Alternativement, elle peut comprendre une première partie adhésive sensible au rayonnement UV et une deuxième partie non adhésive et/ou non sensible au rayonnement UV. La première partie est en contact avec le substrat 110. Par exemple, il peut s'agir d'une fine couche adhésive et d'une base non adhésive, par exemple en polyoléfine.

La couche de protection 130 sensible au rayonnement ultra-violet peut être exposée au rayonnement avant ou après le dépôt de la couche isolante 121.

Après l'étape b), le procédé peut comprendre une étape au cours de laquelle des ouvertures 119 sont formées dans la couche de protection 130. En fonction de la nature de la couche de protection, les ouvertures peuvent être réalisées par action mécanique (scie notamment) ou par laser. Pour une couche de protection 130 soluble dans un solvant, on privilégiera un procédé fonctionnant à sec, par exemple au moyen d'un laser.

Lors de l'étape c), des cavités ou tranchées 120 sont formées dans le substrat 110.

Les cavités ou tranchées 120 définissent les contours latéraux des puces 100. Plus particulièrement, les cavités ou tranchées 120 s'étendent depuis la face supérieure 111 du substrat 110. Les tranchées ou les cavités 120 ont une profondeur et une largeur configurées pour assurer une séparation précise des puces, par exemple, lors de la formation des tranchées ou lors de l'étape d'amincissement du substrat 110.

Selon une première variante de réalisation, par exemple représentée sur les figures 1D et 3B, les tranchées traversent de part en part le substrat 110, c'est-à-dire que le substrat 110 est découpé depuis la première face 111 jusqu'à la deuxième face 112.

L'épaisseur des tranchées 120 est, par exemple, comprise entre 10 et 80 µm.

Selon une deuxième variante de réalisation, par exemple représentée sur la figure 2D, les cavités 120 ont une profondeur inférieure à l'épaisseur du substrat 110.

La profondeur des cavités 120 est, par exemple, comprise entre 10 et 300 µm, de préférence entre 20 et 250 µm.

L'épaisseur des cavités 120 est, par exemple, comprise entre 10 et 80 µm.

Le fond des cavités peut être plat ou concave.

Cette étape c) est réalisée au moyen d'un dispositif de découpe. Le dispositif de découpe est, par exemple, un outil de découpe mécanique comme une scie, ou un outil de gravure par un laser. Selon un mode de réalisation préféré, le dispositif de découpe est un laser. De préférence, la séparation des puces peut être réalisée par découpe laser ou par la technique de découpe par introduction de dislocation par laser (étape dite de 'stealth dicing').

De préférence, pour une couche de protection 130 soluble dans l'eau, la découpe est une découpe laser. Pour une couche de protection 130 adhésive, la découpe peut être une découpe mécanique.

Lorsque des ouvertures 119 ont été préalablement réalisées dans la couche de protection 130, les tranchées ou cavités 120 ont une largeur inférieure ou égale à la largeur des ouvertures 119. De préférence, les tranchées ou cavités 120 ont une largeur inférieure à la largeur des ouvertures 119.

Les ouvertures 119 et les tranchées/cavités 120 peuvent être formées en une même étape, leurs largeurs sont alors identiques.

Lors de l'étape d), une couche isolante 121 est déposée. Le dépôt est réalisé sur la face avant 111 du substrat 110. Le dépôt est un dépôt pleine plaque. La couche isolante 121 est déposée dans les cavités 120, sur la couche de protection 130, et le cas échéant sur la première face du substrat 111 au niveau des ouvertures 119.

La couche isolante 121 est déposée par dépôt de couches minces atomiques (ALD pour `Atomic Layer Déposition'). Le dépôt est un dépôt conforme, même pour de fortes topographies.

La couche isolante 121 est en céramique.

Le couche isolante 121 peut être un nitrure ou un oxyde. Il pourrait également s'agir de borure ou de carbure. De préférence, la couche isolante 121 est en alumine. Il peut également s'agir de TiO₂ ou de Y₂O₃.

Lors de l'étape e), la couche de protection est retirée. Le retrait de la couche de protection 130 permet de retirer simultanément la partie de la couche isolante 121 qui a été déposée dessus.

Lorsque la couche de protection 130 est une couche soluble dans un solvant, celle-ci est mise en contact avec ce solvant, par exemple par immersion ou préférentiellement par un nettoyage à haute pression, pour la retirer. Le solvant peut être un solvant organique ou un solvant aqueux. De préférence, le solvant est de l'eau.

Lorsque la couche de protection 130 est une couche adhésive, elle est retirée selon les sous-étapes suivantes :
- coller une couche adhésive additionnelle 131 au-dessus de la couche de protection 130, et en particulier sur la partie de la couche isolante 121 qui a été déposée sur la couche de protection 130 (figure 3E), puis
- enlever la couche adhésive additionnelle 131 (figure 3F).

Comme la couche adhésive additionnelle 131 adhère à la couche de protection *via* la couche isolante 121, lorsqu'elle est retirée, cela permet de retirer simultanément la couche de protection 130.

Les propriétés d'adhésion seront choisies de manière à ce que, lorsque l'étape e) est réalisée, on retire l'empilement comprenant les couches successives suivantes : la couche de protection 130, la partie de la couche isolante 121 positionnée sur la couche de protection 130, la couche adhésive additionnelle 131.

Le procédé peut également comprendre une étape d'amincissement en face arrière (figure 2G). Cette étape peut être réalisée avant l'étape e). Elle peut aussi être réalisée après l'étape e). Pour cela, la structure est retournée et fixée par sa face avant 111 sur un support 201. Le support 201 est, par exemple, une bande de ruban adhésif. La structure est, ensuite, amincie par sa face arrière 112 de façon que le substrat 110 ait son épaisseur définitive. Lorsque des cavités sont formées à l'étape c), l'étape d'amincissement est, de préférence, réalisée de manière à amincir le substrat 110 jusqu'aux cavités 120 afin de séparer les substrats des puces 100.

A l'issue du procédé, les puces 100 obtenues comprennent des flancs 113 passivés. La passivation est due à la présence de la couche isolante 121 en céramique. Les matériaux de brasage ne mouillent pas la couche isolante 121.

Selon une variante avantageuse, seule une partie du flanc 113 peut être passivée. Les flancs comprennent une première partie formée dans le substrat 110, en matériau semiconducteur, et une deuxième partie isolante 121. La partie passivée du flanc est celle qui est la plus proche de la zone active (i.e. proche des UBM).

Selon une autre variante avantageuse, la totalité du flanc 113 est passivée.

Lorsque des ouvertures 119 ont été formées dans la couche de protection 130, la première face 111 du substrat 110 est également recouverte localement par la couche isolante 121, la couche isolante 121 recouvre alors (partiellement ou totalement) les flancs 113 et se prolonge sur la première face 111 du substrat 110.

Les puces peuvent être des puces dites 'bumpless CSP' avec une simple zone de contact métallique, soudable, électriquement conductrice (UBM, `metal pad', ...) ou des puces dites 'bumped CSP' ayant des connexions additionnelles en relief de la puce seule ('bump', 'pillar', ...).

Les puces 100 peuvent ensuite être fixées sur un dispositif externe, par exemple, une carte de circuit imprimé ou un autre composant, par leur face supérieure 111.

Pour cela, un matériau de brasage est positionné entre la puce 103 et le dispositif externe. Lors du brasage, même si le matériau de brasage remonte le long des flancs des puces, elles fonctionneront correctement.

De telles puces électroniques de type CSP trouvent des applications dans de nombreux domaines industriels, et en particulier, dans le domaine de la téléphonie, dans le domaine automobile ou le domaine médical.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Procédé de fabrication d'une puce électronique (100) à flancs passivés à partir d'un substrat (110) semiconducteur dont une première face (111) est recouverte par des plages de connexion (107) et dans lequel sont formées des puces (100), le procédé comprenant les étapes suivantes :
- déposer une couche de protection (130) sur la première face (111) du substrat (110), la couche de protection (130) étant une couche soluble dans l'eau ou une couche adhésive sensible au rayonnement ultra-violet,
- former des tranchées ou cavités (120) entre les puces (100),
- déposer une couche isolante (121) en céramique dans les tranchées ou dans les cavités (120) par dépôt de couches atomiques, la couche isolante (121) étant en alumine,
- retirer la couche de protection (130).

2. Procédé selon la revendication 1, dans lequel des tranchées (120) sont formées, les tranchées allant de la première face (111) du substrat (110) à une deuxième face (112) du substrat (110).

3. Procédé selon la revendication 1, dans lequel des cavités (120) sont formées en découpant partiellement le substrat (110) depuis la première face (111).

4. Procédé selon la revendication 3, le procédé comprenant une étape au cours de laquelle le substrat (110) est aminci à partir d'une deuxième face (112) du substrat (110) jusqu'à atteindre les cavités (120).

5. Procédé selon l'une des revendications précédentes, dans lequel les tranchées ou les cavités (120) ont une profondeur et une largeur configurées pour assurer une séparation des puces.

6. Procédé selon l'une des revendications 1 à 5, dans lequel, avant ou après le dépôt de la couche isolante (121), le procédé comprend une étape au cours de laquelle la couche de protection (130) adhésive sensible au rayonnement ultra-violet est soumise à un rayonnement ultra-violet pour diminuer ses propriétés d'adhésion.

7. Procédé selon la revendication précédente, dans lequel l'étape de retrait de la couche de protection (130) est réalisée en collant une couche adhésive additionnelle (131) et en retirant simultanément la couche adhésive additionnelle (131) et la couche de protection (130).

8. Puce électronique (100) à flancs passivés comprenant un substrat (110) semiconducteur, ayant une première face (111) recouverte par des plages de connexion (107), une deuxième face (112) et des flancs (113), au moins une partie des flancs (113) étant formée d'une couche isolante (121) en céramique s'étendant depuis la première face (111) du substrat (110), la couche isolante (121) étant en alumine.

9. Puce électronique (100) selon la revendication 8, dans laquelle la couche isolante (121) recouvre une partie de la première face (111).
